# EUROPÄISCHE PATENTANMELDUNG

(11) **EP 3 796 018 A1**
(43) Veröffentlichungstag der Anmeldung: **24.03.2021**
(21) Anmeldenummer: 19197786.7
(22) Anmeldetag: 17.09.2019
(51) Int. Cl.: G01R 33/28

(54) **MAGNETRESONANZVORRICHTUNG MIT EINER PATIENTENUNTERHALTUNGSEINHEIT, EIN VERFAHREN ZU EINER STEUERUNG EINER PATIENTENUNTERHALTUNGSEINHEIT EINER MAGNETRESONANZVORRICHTUNG UND ENTSPRECHENDES COMPUTERPROGRAMMPRODUKT**

(71) Anmelder: Siemens Healthcare GmbH, 91052 Erlangen (DE)
(72) Erfinder: Gühring, Jens, 91052 Erlangen (DE); Hetz, Christian, 91362 Pretzfeld (DE); Ludwig, Kirsten, 90592 Schwarzenbruck (DE); Petsch, Markus, 91056 Erlangen (DE); Schnell, Wilfried, 91301 Forchheim (DE)

(57) **Zusammenfassung**

Die Erfindung geht aus von einer Magnetresonanzvorrichtung mit einem Patientenaufnahmebereich und einer Patientenunterhaltungseinheit, wobei die Patientenunterhaltungseinheit eine außerhalb des Patientenaufnahmebereichs angeordnete Bildbereitstellungseinheit und eine Bildansichtseinheit aufweist, wobei die Bildbereitstellungseinheit eine Recheneinheit umfasst, wobei mittels der Recheneinheit eine Bildgröße eines bereitgestellten Bildes der Bildbereitstellungseinheit einstellbar ist.

## Beschreibung

Die vorliegende Erfindung betrifft eine Magnetresonanzvorrichtung mit einem Patientenaufnahmebereich, einem innerhalb des Patientenaufnahmebereichs bewegbaren Patiententisch zur Lagerung und/oder Positionierung eines Patienten und einer Patientenunterhaltungseinheit, wobei die Patientenunterhaltungseinheit eine Bildbereitstellungseinheit und eine Bildansichtseinheit aufweist. Des Weiteren geht die vorliegende Erfindung aus von einem Verfahren zu einer Steuerung einer Patientenunterhaltungseinheit einer Magnetresonanzvorrichtung mittels einer Recheneinheit. Die vorliegende Erfindung geht zudem von einem Computerprogrammprodukt aus, das bei einem Ausführen auf einem Prozessor einer Recheneinheit das erfindungsgemäße Verfahren zu einer Steuerung einer Patientenunterhaltungseinheit einer Magnetresonanzvorrichtung ausführt.

Magnetresonanzuntersuchungen an einem Patienten umfassen häufig eine längere Zeitdauer, die von einigen Minuten bis zu einer Stunde und länger dauern kann. Während dieser Zeit steht dem Patienten häufig eine Patientenunterhaltungseinheit zur Verfügung, um den Patienten über die Magnetresonanzuntersuchung zu informieren und/oder den Patienten zu unterhalten. Derartige Patientenunterhaltungseinheiten weisen für gewöhnlich einen Projektor auf, der außerhalb eines Patientenaufnahmebereichs einer Magnetresonanzvorrichtung angeordnet ist und ein Bild und/oder eine Information in den Patientenaufnahmebereichs, insbesondere auf eine Projektionsfläche innerhalb des Patientenaufnahmebereichs, projiziert. Für die Projektion wird zwar häufig eine Position der Projektionsfläche berücksichtigt, um ein projiziertes Bild auf den Auftreffort oder die Projektionsfläche zu fokussieren. Jedoch wird dabei nicht ein Abstand zur Projektionsfläche zur Einstellung des Projektors berücksichtigt. Dies kann jedoch dazu führen, dass eine dargestellte Information und/oder ein dargestelltes Bild für den Patienten zur schwierig zu erfassen ist.

Zudem sind Patientenunterhaltungseinheit bekannt, die eine Videobrille umfassen, wobei die Videobrille von dem Patienten während der Magnetresonanzuntersuchung aufgesetzt werden kann. Derartige Videobrillen weisen bei der Verwendung bei Magnetresonanzuntersuchungen jedoch die Schwierigkeit auf, dass die Videobrillen innerhalb des Patientenaufnahmebereichs und damit innerhalb eines Fields of View (FOVs) während einer Magnetresonanzuntersuchung angeordnet sein können und damit auch die Magnetresonanzuntersuchung unerwünscht beeinträchtigen können.

Der vorliegenden Erfindung liegt insbesondere die Aufgabe zugrunde, eine Patientenunterhaltungseinheit für eine Magnetresonanzuntersuchung bereitzustellen, die sowohl eine störungsfreie Magnetresonanzuntersuchung als auch gute Erfassbarkeit einer dargestellten Information und/oder eines dargestellten Bildes für einen Patienten ermöglicht. Die Aufgabe wird durch die Merkmale der unabhängigen Ansprüche gelöst. Vorteilhafte Ausgestaltungen sind in den Unteransprüchen beschrieben.

Die Erfindung geht aus von eine Magnetresonanzvorrichtung mit einem Patientenaufnahmebereich und einer Patientenunterhaltungseinheit, wobei die Patientenunterhaltungseinheit eine außerhalb des Patientenaufnahmebereichs angeordnete Bildbereitstellungseinheit und eine Bildansichtseinheit aufweist. Erfindungsgemäß umfasst die Bildbereitstellungseinheit eine Recheneinheit, wobei mittels der Recheneinheit eine Bildgröße eines bereitgestellten Bildes der Bildbereitstellungseinheit einstellbar ist.

Die Magnetresonanzvorrichtung umfasst typischerweise eine Scannereinheit mit einem Grundmagneten. Der Grundmagnet ist zu einem Erzeugen eines starken, homogenen und konstanten Grundmagnetfelds ausgelegt, wobei der Grundmagnet derart ausgebildet ist, dass das starke, homogene und konstante Grundmagnetfeld in einem Patientenaufnahmebereich, insbesondere in einem Field of View (FOV), der Magnetresonanzvorrichtung angelegt und/oder angeordnet ist. Des Weiteren umfasst die Scannereinheit bevorzugt eine Gradientenspuleneinheit. Die Gradientenspuleneinheit ist zu einer Erzeugung von Magnetfeldgradienten für eine Ortskodierung innerhalb des Patientenaufnahmebereichs, insbesondere innerhalb des FOVs, während einer Magnetresonanzbildgebung ausgelegt und/oder ausgebildet. Weiterhin umfasst die Scannereinheit bevorzugt eine Hochfrequenzantenneneinheit, wobei die Hochfrequenzantenneneinheit fest innerhalb der Scannereinheit integriert ist. Mittels der Hochfrequenzantenneneinheit können während einer Magnetresonanzuntersuchung vorteilhaft hochfrequente Magnetresonanzsequenzen generiert und in den Patientenaufnahmebereich, insbesondere in das FOV, zur Anregung ausgesendet und/oder ausgestrahlt werden.

Die Magnetresonanzvorrichtung umfasst weiterhin den Patientenaufnahmebereich, der zumindest teilweise von der Scannereinheit umgeben ist. Beispielsweise kann der Patientenaufnahmebereich zylinderförmig von der Scannereinheit umgeben sein. Der Patientenaufnahmebereich ist zur Aufnahme des Patienten und/oder eines zu untersuchenden Bereichs des Patienten während einer Magnetresonanzuntersuchung ausgelegt und/oder ausgebildet. Der Patientenaufnahmebereich umfasst bevorzugt das FOV und/oder das Isozentrum der Magnetresonanzvorrichtung. Das FOV umfasst bevorzugt einen Erfassungsbereichs der Magnetresonanzvorrichtung, innerhalb dessen Magnetresonanzdaten erfasst werden können. Das Isozentrum der Magnetresonanzvorrichtung umfasst bevorzugt den Bereich und/oder Punkt innerhalb der Magnetresonanzvorrichtung, der die optimalsten und/oder idealsten Bedingungen für eine Magnetresonanzuntersuchung aufweist. Insbesondere umfasst das Isozentrum den homogensten Bereich innerhalb der Magnetresonanzvorrichtung. Vorzugsweise ist das Isozentrum innerhalb des Patientenaufnahmebereichs angeordnet.

Innerhalb des Patientenaufnahmebereichs ist für gewöhnlich eine Patientenlagerungsvorrichtung bewegbar angeordnet. Insbesondere ist hierbei ein Patiententisch der Patientenlagerungsvorrichtung in eine z-Richtung der Scannereinheit und/oder in Richtung einer Längserstreckung des Patientenaufnahmebereichs bewegbar angeordnet. Auf dem Patiententisch ist der Patient für die Magnetresonanzuntersuchung positioniert. Mittels der Patientenlagerungsvorrichtung, insbesondere des bewegbaren Patiententischs, kann ein Patient, insbesondere ein zu untersuchender Bereich des Patienten, in den Patientenaufnahmebereich für eine Magnetresonanzuntersuchung eingebracht und/oder eingefahren werden und/oder für eine Magnetresonanzuntersuchung innerhalb des Patientenaufnahmebereichs positioniert werden.

Die Patientenunterhaltungseinheit umfasst bevorzugt eine visuelle Patientenunterhaltungseinheit, die die Bildbereitstellungseinheit und die Bildansichtseinheit umfasst. Die Bildbereitstellungseinheit ist dazu ausgelegt und/oder ausgebildet, visuelle Informationen und/oder Bilder für eine Ansicht durch den Patienten während einer Magnetresonanzuntersuchung bereitzustellen. Hierzu kann die Bildbereitstellungseinheit eine Projektionseinheit, insbesondere einen Projektor, und/oder einen Monitor und/oder ein Display umfassen. Die Bildbereitstellungseinheit ist dabei außerhalb des Patientenaufnahmebereichs angeordnet, um eine unerwünschte Interaktion mit einer Magnetresonanzmessung und/oder der Scannereinheit der Magnetresonanzvorrichtung während der Magnetresonanzuntersuchung zu verhindern.

Die Bildansichtseinheit ist dazu ausgebildet und/oder ausgelegt, die von der Bildbereitstellungseinheit während der Magnetresonanzuntersuchung für den Patienten bereitgestellten Informationen und/oder Daten, insbesondere Bilder, anzuzeigen und/oder darzustellen. Hierzu kann die Bildansichtseinheit eine Projektionsfläche und/oder eine Projektionsleinwand und/oder einen Projektionsspiegel usw. aufweisen. Die Bildansichtseinheit kann dabei innerhalb des Patientenaufnahmebereichs der Scannereinheit angeordnet sein. Zudem kann die Patientenunterhaltungseinheit auch eine akustische Patientenunterhaltungseinheit umfassen, wie beispielweise in Form von Patienten-Kopfhörern.

Die erfindungsgemäße Recheneinheit der Patientenunterhaltungseinheit umfasst zumindest ein Rechenmodul und/oder einen Prozessor. So ist insbesondere die Recheneinheit dazu ausgebildet, computerlesbare Instruktionen auszuführen, um die Patientenunterhaltungseinheit, insbesondere die Bildbereitstellungseinheit, einzustellen und/oder zu steuern. Insbesondere umfasst die Recheneinheit eine Speichereinheit, wobei auf der Speichereinheit computerlesbare Informationen gespeichert sind, wobei die Recheneinheit dazu ausgebildet ist, die computerlesbaren Informationen von der Speichereinheit zu laden und die computerlesbaren Informationen auszuführen, um die Patientenunterhaltungseinheit, insbesondere die Bildbereitstellungseinheit, einzustellen und/oder zu steuern. Derart ist die Recheneinheit dazu ausgebildet, die Patientenunterhaltungseinheit, insbesondere die Bildbereitstellungseinheit, einzustellen und/oder zu steuern.

Die Komponenten der Recheneinheit können zum überwiegenden Teil in Form von Softwarekomponenten ausgebildet sein. Grundsätzlich können diese Komponenten aber auch zum Teil, insbesondere wenn es um besonders schnelle Berechnungen geht, in Form von softwareunterstützten Hardwarekomponenten, beispielsweise FPGAs oder dergleichen, realisiert sein. Ebenso können die benötigten Schnittstellen, beispielsweise wenn es nur um eine Übernahme von Daten aus anderen Softwarekomponenten geht, als Softwareschnittstellen ausgebildet sein. Sie können aber auch als hardwaremäßig aufgebaute Schnittstellen ausgebildet sein, die durch geeignete Software angesteuert werden. Selbstverständlich ist es auch denkbar, dass mehrere der genannten Komponenten in Form einer einzelnen Softwarekomponente bzw. softwareunterstützter Hardwarekomponente zusammengefasst realisiert sind.

Mittels der Recheneinheit ist eine Bildgröße eines bereitgestellten Bildes der Bildbereitstellungseinheit einstellbar. Dabei ist die Recheneinheit zu einer digitalen Einstellung einer Bildgröße und/oder zu einer mechanischen Einstellung einer Bildgröße ausgelegt und/oder ausgebildet. Vorzugsweise ist die Recheneinheit dazu ausgelegt und/oder ausgebildet, die Bildgröße eines bereitgestellten Bildes der Bildbereitstellungseinheit anhand von insbesondere einer Patientenposition und/oder einer Position der Bildansichtseinheit einzustellen.

Durch die erfindungsgemäße Ausgestaltung kann vorteilhaft eine Patientenunterhaltung während einer Magnetresonanzuntersuchung bereitgestellt werden, bei der insbesondere eine Patientenposition und/oder eine Position der Bildansichtseinheit zur Einstellung einer Bildgröße von der Recheneinheit berücksichtigt werden kann. Insbesondere kann derart eine auf der Bildansichtseinheit dargestellte Größe eines bereitgestellten Bildes an eine Ansichtseinstellung eines Patienten angepasst werden. Weiterhin kann auch eine auf der Bildansichtseinheit dargestellte Größe eines bereitgestellten Bildes unabhängig von einem Abstand der Bildansichtseinheit zu der Bildbereitstellungseinheit mit einer gleichbleibenden Größe eingestellt werden, und damit auch eine vorteilhafte Darstellung für den Patienten erreicht werden. Insbesondere kann derart die Einstellung einer Bildgröße eines bereitgestellten Bildes der Bildbereitstellungseinheit automatisch und/oder selbsttätig erfolgen. Hierdurch kann eine besonders komfortable und benutzerfreundliche Einstellung der Bildgröße für einen Benutzer erreicht und/oder bereitgestellt werden. Des Weiteren kann derart auch eine Behinderung der Magnetresonanzuntersuchung durch die Patientenunterhaltungseinheit vorteilhaft verhindert werden.

In einer vorteilhaften Weiterbildung der erfindungsgemäßen Magnetresonanzvorrichtung kann es vorgesehen sein, dass mittels der Recheneinheit die Bildgröße eines bereitgestellten Bildes der Bildbereitstellungseinheit in Abhängigkeit von zumindest einen Untersuchungsparameter einstellbar ist. Der zumindest eine Untersuchungsparameter umfasst bevorzugt einen Positionsparameter und/oder einen Abstandsparameter. Der zumindest eine Untersuchungsparameter kann beispielsweise eine Position eines innerhalb des Patientenaufnahmebereichs bewegbaren Patiententischs sein, wobei an dem Patiententisch die Bildansichtseinheit der Patientenunterhaltungseinheit angeordnet sein kann. Des Weiteren kann der zumindest eine Untersuchungsparameter eine Patientenposition innerhalb des Patientenaufnahmebereichs umfassen. Alternativ oder zusätzlich kann der zumindest eine Untersuchungsparameter auch eine Position einer Zubehöreinheit innerhalb des Patientenaufnahmebereichs umfassen, wie beispielsweise eine Kopf-Hochfrequenzantenneneinheit, an der die Bildansichtseinheit der Patientenunterhaltungseinheit angeordnet sein kann. Alternativ oder zusätzlich kann der zumindest eine Untersuchungsparameter auch einen Abstand umfassen, wie beispielsweise einen Abstand der Bildbereitstellungseinheit zur Bildansichtseinheit, insbesondere zu einer Projektionsfläche der Bildansichtseinheit. Zudem sind weitere, dem Fachmann als sinnvoll erscheinende Untersuchungsparameter jederzeit möglich. Diese Ausgestaltung der Erfindung ermöglicht eine einfache Einstellung und/oder Anpassung einer Bildgröße, so dass unabhängig von einer Entfernung des Patienten zu der Bildbereitstellungseinheit stets eine gleiche Bildgröße, insbesondere eine für den Patienten gut erfassbare und/oder gut sichtbare Bildgröße, in der Bildansichtseinheit dargestellt werden kann. Dies ermöglicht auch eine gute Sichtbarkeit der angezeigten Informationen mittels der Bildansichtseinheit für einen Patienten während einer Magnetresonanzuntersuchung.

In einer vorteilhaften Weiterbildung der erfindungsgemäßen Magnetresonanzvorrichtung kann es vorgesehen sein, dass die Bildbereitstellungseinheit zumindest eine Sensoreinheit zu einer Erfassung und/oder Bestimmung des zumindest einen Untersuchungsparameters aufweist. Die zumindest eine Sensoreinheit kann beispielsweise eine Kamera und/oder einen Abstandslaser umfassen, wobei mittels der Kamera und/oder mittels des Abstandslasers der ein Abstand zwischen der Bildbereitstellungseinheit und der Bildansichtseinheit und/oder ein Abstand zwischen der Bildbereitstellungseinheit und dem Patienten und/oder ein Abstand zwischen der Bildbereitstellungseinheit und einer Zubehöreinheit, die auf dem Patiententisch angeordnet ist, und/oder einen Abstand zwischen der Bildbereitstellungseinheit und einer Position des Patiententischs, insbesondere einer definierten Position des Patiententischs, erfassbar ist. Zudem sind weitere, dem Fachmann als sinnvoll erscheinende Sensoreinheiten zur Erfassung und/oder Bestimmung des zumindest einen Untersuchungsparameters, insbesondere des Abstandsparameters und/oder des Positionsparameters, jederzeit denkbar. Diese Ausgestaltung der Erfindung ermöglicht besonders vorteilhaft eine automatische und/oder selbsttätige Einstellung und/oder Anpassung einer Bildgröße eines mittels der Bildbereitstellungseinheit bereitgestellten Bildes. Hierdurch kann eine besonders komfortable und benutzerfreundliche Einstellung der Bildgröße für einen Benutzer erreicht und/oder bereitgestellt werden. Aufgrund der Einstellung der Bildgröße kann zudem eine gut erfassbare Darstellung des von der Bildbereitstellungseinheit bereitgestellten Bildes auf der Bildansichtseinheit für einen Patienten erreicht werden.

In einer vorteilhaften Weiterbildung der erfindungsgemäßen Magnetresonanzvorrichtung kann es vorgesehen sein, dass die Magnetresonanzvorrichtung eine Datenübertragungseinheit aufweist, wobei mittels der Datenübertragungseinheit der zumindest eine Untersuchungsparameter an die Recheneinheit der Patientenunterhaltungseinheit übertragen wird. Vorzugsweise ist der mittels der Datenübertragungseinheit übertragbare zumindest eine Untersuchungsparameter ein für die anstehende Magnetresonanzuntersuchung feststehender und/oder festgelegter Parameter, insbesondere Positionsparameter und/oder Abstandsparameter. Beispielsweise kann es bei ausgewählten Magnetresonanzuntersuchungen vorgesehen sein, dass eine definierte Position des Patienten und/oder des Patiententischs innerhalb des Patientenaufnahmebereichs feststeht. Diese Position kann somit besonders einfach an die Recheneinheit zur Einstellung und/oder Anpassung der Bildgröße eines mittels der Bildbereitstellungseinheit bereitgestellten Bildes übermittelt werden. Besonders vorteilhaft ist der mittels der Datenübertragungseinheit übertragbare zumindest eine Untersuchungsparameter innerhalb einer Systemsteuereinheit und/oder einer Speichereinheit der Magnetresonanzvorrichtung hinterlegt und/oder gespeichert und wird mittels der Datenübertragungseinheit an die Recheneinheit übertragen. Die Datenübertragungseinheit kann dabei zu einer kabelgebundenen Datenübertragung und/oder einer kabellosen Datenübertragung ausgelegt und/oder ausgebildet sein. Diese Ausgestaltung der Erfindung ermöglicht besonders vorteilhaft eine automatische und/oder selbsttätige Einstellung und/oder Anpassung einer Bildgröße eines mittels der Bildbereitstellungseinheit bereitgestellten Bildes. Hierdurch kann eine besonders komfortable und benutzerfreundliche Einstellung der Bildgröße für einen Benutzer erreicht und/oder bereitgestellt werden.

In einer vorteilhaften Weiterbildung der erfindungsgemäßen Magnetresonanzvorrichtung kann es vorgesehen sein, dass die Bildbereitstellungseinheit eine Zoomeinheit umfasst. Die Zoomeinheit kann beispielsweise eine motorgesteuerte Zoomeinheit und eine Optikeinheit, insbesondere eine einstellbare Optikeinheit eines Projektors, umfassen. Die Optikeinheit, insbesondere die einstellbare Optikeinheit, umfasst bevorzugt eine optische Linseneinheit mit einzelnen optischen Linsenelementen. Die motorgesteuerte Zoomeinheit umfasst bevorzugt einen Einstellmotor, der von der Recheneinheit gesteuert wird, wobei mittels des Einstellmotors ein Abstand zwischen einzelnen optischen Elementen, insbesondere zwischen optischen Linsenelementen, der Optikeinheit, insbesondere die einstellbare Optikeinheit, einstellbar ist. Alternativ oder zusätzlich kann es vorgesehen sein, dass die Zoomeinheit eine digitale Zoomeinheit umfasst, bei der lediglich ein Bildausschnitt vergrößert mittels der Bildbereitstellungseinheit bereitgestellt wird. Beispielsweise kann hierbei die Bildbereitstellungseinheit eine feststehende Optikeinheit, insbesondere eine nicht einstellbare Optikeinheit, und/oder ein Display umfassen. Bevorzugt weist hierbei die Bildbereitstellungseinheit eine hohe Auflösung auf, um eine hohe Bildschärfe der bereitgestellten Bilder und/oder Informationen zu erhalten. Hierdurch kann eine konstruktiv einfache Einstellung einer Bildgröße eines bereitgestellten Bildes der Bildbereitstellungseinheit erreicht werden. Insbesondere kann derart die Einstellung einer Bildgröße eines bereitgestellten Bildes der Bildbereitstellungseinheit automatisch und/oder selbsttätig erfolgen und somit ein hoher Bedienkomfort für einen Benutzer bereitgestellt werden.

In einer vorteilhaften Weiterbildung der erfindungsgemäßen Magnetresonanzvorrichtung kann es vorgesehen sein, dass die Bildbereitstellungseinheit eine Projektionseinheit umfasst, an der die Zoomeinheit angeordnet ist. Die Projektionseinheit umfasst bevorzugt einen Projektor, wobei mittels des Projektors ein Bild bereitgestellt werden und auf die Bildansichtseinheit projiziert werden kann. Umfasst der Projektor beispielsweise einen digitalen Projektor, kann dieser eine feststehende Optikeinheit, insbesondere eine nicht einstellbare Optikeinheit, umfassen, wobei mittels der digitalen Zoomeinheit, insbesondere der Recheneinheit, eine Einstellung einer Bildgröße und/oder eines Bildausschnitts vorgenommen werden kann. Umfasst der Projektor eine einstellbare Optikeinheit, ist an der einstellbaren Optikeinheit bevorzugt die Zoomeinheit, insbesondere die motorgesteuerte Zoomeinheit, angeordnet. Diese Ausgestaltung der Erfindung ermöglicht eine konstruktiv einfache Einstellung einer Bildgröße eines bereitgestellten Bildes der Bildbereitstellungseinheit.

In einer vorteilhaften Weiterbildung der erfindungsgemäßen Magnetresonanzvorrichtung kann es vorgesehen sein, dass die Bildbereitstellungseinheit ein Display umfasst. Hierdurch kann eine besonders kompakte und bauraumsparende Bildbereitstellungseinheit erreicht werden. Besonders vorteilhaft weist hierbei die Bildansichtseinheit nur einen Spiegel auf, wobei mittels des Spiegels eine direkte Sicht auf das Display für einen Patienten während einer Magnetresonanzuntersuchung ermöglicht wird.

In einer vorteilhaften Weiterbildung der erfindungsgemäßen Magnetresonanzvorrichtung kann es vorgesehen sein, dass die Bildbereitstellungseinheit eine Positioniereinheit zur Positionierung des bereitgestellten Bildes in horizontaler Richtung und/oder in vertikaler Richtung umfasst. Insbesondere kann hierbei mittels der Positioniereinheit eine Positionierung und/oder eine Verschiebung des auf der Bildansichtseinheit dazustellenden Bildes in horizontaler Richtung unabhängig sein von einer Positionierung und/oder Verschiebung des auf der Bildansichtseinheit dazustellenden Bildes in vertikaler Richtung. Die die Positioniereinheit und damit die Positionierung und/oder die Verschiebung des darzustellenden Bildes wird bevorzugt mittels der Recheneinheit gesteuert. Die Positioniereinheit kann dabei eine mechanische Positioniereinheit umfassen, wobei die Positioniereinheit an der Bildbereitstellungseinheit und/oder an einer Befestigung der Bildbereitstellungseinheit angeordnet sein kann. Zudem kann auch eine elektronische Anpassung auf einem Monitor und/oder einem Projektor mittels der Recheneinheit, die die Positioniereinheit umfassen kann, erfolgen. Derart kann besonders vorteilhaft die Bildbereitstellungseinheit auf unterschiedliche Bildansichtseinheiten und/oder auf unterschiedliche Einheiten, wie beispielsweise auf unterschiedlich große Kopf-Hochfrequenzantenneneinheiten, an denen die Bildansichtseinheit angeordnet werden kann, angepasst werden. Dies ermöglicht einen besonders flexiblen Einsatz der Patientenunterhaltungseinheit bei einer gleichbleibend hohen Bildqualität der auf der Bildansichtseinheit dargestellten Bilder für einen Patienten während einer Magnetresonanzuntersuchung.

In einer vorteilhaften Weiterbildung der erfindungsgemäßen Magnetresonanzvorrichtung kann es vorgesehen sein, dass die Bildansichtseinheit einen Projektionsspiegel und/oder eine Projektionsleinwand umfasst. Derart kann eine besonders einfache Darstellung von Informationen und/oder Bildern für einen Patienten während einer Magnetresonanzuntersuchung erreicht werden. Insbesondere kann derart auch eine besonders störungsfreie Darstellung von Informationen und/oder Bildern für einen Patienten während einer Magnetresonanzuntersuchung erreicht werden. Weist beispielsweise die Bildbereitstellungseinheit eine Projektionseinheit auf, kann die Bildansichtseinheit eine Projektionsleinwand und einen Projektionsspiegel aufweisen. Weist dagegen die die Bildbereitstellungseinheit ein Display auf, reicht es aus, wenn die Bildansichtseinheit lediglich einen Projektionsspiegel zur Darstellung der bereitgestellten Bilder aufweist.

In einer vorteilhaften Weiterbildung der erfindungsgemäßen Magnetresonanzvorrichtung kann es vorgesehen sein, dass die Bildansichtseinheit während einer Magnetresonanzuntersuchung an dem Patienten innerhalb des Patientenaufnahmebereichs angeordnet ist. Dabei kann die Bildansichtseinheit direkt an einer den Patientenaufnahmebereich umgebende Wandung der Scannereinheit angeordnet sein. Zudem kann die Bildansichtseinheit auch an der Patientenlagerungsvorrichtung, insbesondere an dem bewegbaren Patiententisch der Patientenlagerungsvorrichtung, angeordnet sein, so dass die Bildansichtseinheit zusammen mit dem Patienten bei einer Verschiebung und/oder Positionierung des Patiententischs bewegt wird. Hierbei kann bevorzugt die Bildansichtseinheit an einem Kopfende des Patiententischs angeordnet sein. Hierdurch kann eine vorteilhafte Sicht für einen Patienten auf die Bildansichtseinheit während einer Magnetresonanzuntersuchung an dem Patienten erreicht werden.

In einer vorteilhaften Weiterbildung der erfindungsgemäßen Magnetresonanzvorrichtung kann es vorgesehen sein, dass die Magnetresonanzvorrichtung eine Zubehöreinheit umfasst, wobei die Bildansichtseinheit auch an der Zubehöreinheit angeordnet ist. Die Zubehöreinheit kann besonders vorteilhaft eine Kopf-Hochfrequenzantenneneinheit umfassen, die für eine Kopf-Magnetresonanzuntersuchung an dem Patienten um den Kopf des Patienten angeordnet ist. Die Zubehöreinheit, insbesondere der lokale Kopf-Hochfrequenzantenneneinheit, ist bevorzugt an dem Patiententisch angeordnet. Hierdurch kann eine vorteilhafte Sicht für einen Patienten auf die Bildansichtseinheit unabhängig von einer Position des Patienten während einer Magnetresonanzuntersuchung an dem Patienten erreicht werden.

Des Weiteren geht die Erfindung aus von einem Verfahren zu einer Steuerung einer Patientenunterhaltungseinheit einer Magnetresonanzvorrichtung mittels einer Recheneinheit, wobei das Verfahren die folgenden Verfahrensschritte umfasst:
- Bereitstellen zumindest eines Untersuchungsparameters der Magnetresonanzuntersuchung und
- Einstellen einer Bildgröße eines bereitgestellten Bildes einer Bildbereitstellungseinheit der Patientenunterhaltungseinheit in Abhängigkeit von dem zumindest einen Untersuchungsparameter.

Die Patientenunterhaltungseinheit umfasst bevorzugt die Bildbereitstellungseinheit und eine Bildansichtseinheit. Mittels der Bildbereitstellungseinheit wird ein Bild und/oder eine Information für den Patienten bereitgestellt. Mittels der Bildansichtseinheit kann das bereitgestellte Bild für den Patienten, insbesondere in einem Sichtbereich und/oder einem Blickfeld des Patienten während der Magnetresonanzuntersuchung, dargestellt und/oder angezeigt werden. Zudem umfasst die Patientenunterhaltungseinheit die Recheneinheit.

Durch das erfindungsgemäße Verfahren kann vorteilhaft eine Patientenunterhaltung während einer Magnetresonanzuntersuchung bereitgestellt werden, bei der insbesondere eine Patientenposition und/oder eine Position der Bildansichtseinheit zur Einstellung einer Bildgröße von der Recheneinheit berücksichtigt werden kann. Insbesondere kann derart eine auf der Bildansichtseinheit dargestellte Größe eines bereitgestellten Bildes an eine Ansichtseinstellung eines Patienten angepasst werden. Weiterhin kann auch eine auf der Bildansichtseinheit dargestellte Größe eines bereitgestellten Bildes unabhängig von einem Abstand der Bildansichtseinheit zu der Bildbereitstellungseinheit mit einer gleichbleibenden Größe eingestellt werden, und damit auch eine vorteilhafte Darstellung für den Patienten erreicht werden. Insbesondere kann derart die Einstellung einer Bildgröße eines bereitgestellten Bildes der Bildbereitstellungseinheit automatisch und/oder selbsttätig erfolgen und somit ein hoher Bedienkomfort für einen Benutzer bereitgestellt werden. Des Weiteren kann derart auch eine Behinderung der Magnetresonanzuntersuchung durch die Patientenunterhaltungseinheit vorteilhaft verhindert werden.

Die Vorteile des erfindungsgemäßen Verfahrens zu einer Steuerung einer Patientenunterhaltungseinheit einer Magnetresonanzvorrichtung mittels einer Recheneinheit entsprechen im Wesentlichen den Vorteilen der erfindungsgemäßen Magnetresonanzvorrichtung, welche vorab im Detail ausgeführt sind. Hierbei erwähnte Merkmale, Vorteile oder alternative Ausführungsformen können auch auf die anderen beanspruchten Gegenstände übertragen werden und umgekehrt.

In einer vorteilhaften Weiterbildung des erfindungsgemäßen Verfahrens kann es vorgesehen sein, dass das Bereitstellen des zumindest einen Untersuchungsparameters ein Erfassen des zumindest einen Untersuchungsparameters mittels zumindest einer Sensoreinheit umfasst. Die Sensoreinheit ist bevorzugt von der Patientenunterhaltungseinheit, insbesondere von der Bildbereitstellungseinheit der Patientenunterhaltungseinheit umfasst. Der zumindest eine Untersuchungsparameter umfasst bevorzugt einen Positionsparameter und/oder einen Abstandsparameter. Die zumindest eine Sensoreinheit kann beispielsweise eine Kamera und/oder einen Abstandslaser umfassen, mittels der ein Abstandsparameter und/oder ein Positionsparameter erfasst werden kann. Diese Ausgestaltung der Erfindung ermöglicht besonders vorteilhaft eine automatische und/oder selbsttätige Einstellung und/oder Anpassung einer Bildgröße eines mittels der Bildbereitstellungseinheit bereitgestellten Bildes. Hierdurch kann eine besonders komfortable und benutzerfreundliche Einstellung der Bildgröße für einen Benutzer erreicht und/oder bereitgestellt werden.

In einer vorteilhaften Weiterbildung des erfindungsgemäßen Verfahrens kann es vorgesehen sein, dass das Bereitstellen des zumindest einen Untersuchungsparameters ein Übertragen des zumindest einen Untersuchungsparameters an die Recheneinheit umfasst. Vorzugsweise wird hierbei der zumindest eine Untersuchungsparameter von einer Steuerungseinheit und/oder einer Einstelleinheit und/oder einer Speichereinheit der Magnetresonanzvorrichtung an die Recheneinheit der Patientenunterhaltungseinheit übertragen. Die Übertragung des zumindest einen Untersuchungsparameters erfolgt bevorzugt mittels einer Datenübertragungseinheit, wobei die Datenübertragungseinheit dabei zu einer kabelgebundenen Datenübertragung und/oder einer kabellosen Datenübertragung ausgelegt und/oder ausgebildet sein kann. Vorzugsweise ist der mittels der Datenübertragungseinheit übertragbare zumindest eine Untersuchungsparameter ein für die anstehende Magnetresonanzuntersuchung feststehender und/oder festgelegter Parameter, insbesondere Positionsparameter und/oder Abstandsparameter. Beispielsweise kann es bei ausgewählten Magnetresonanzuntersuchungen vorgesehen sein, dass eine definierte Position des Patienten innerhalb des Patientenaufnahmebereichs feststeht. Diese Position kann somit besonders einfach an die Recheneinheit zur Einstellung und/oder Anpassung der Bildgröße eines mittels der Bildbereitstellungseinheit bereitgestellten Bildes übermittelt werden. Diese Ausgestaltung der Erfindung ermöglicht besonders vorteilhaft eine automatische und/oder selbsttätige Einstellung und/oder Anpassung einer Bildgröße eines mittels der Bildbereitstellungseinheit bereitgestellten Bildes. Zudem kann hierdurch eine besonders komfortable und benutzerfreundliche Einstellung der Bildgröße für einen Benutzer erreicht und/oder bereitgestellt werden.

In einer vorteilhaften Weiterbildung des erfindungsgemäßen Verfahrens kann es vorgesehen sein, dass die Einstellung der Bildgröße eine Positionierung des auf der Bildansichtseinheit dazustellenden Bildes umfasst. Die Positionierung kann dabei eine Positionierung und/oder eine Verschiebung des dazustellenden Bildes in horizontaler Richtung und/oder in vertikaler Richtung auf bevorzugt einer Darstellungsfläche, insbesondere einer Projektionsfläche, der Bildansichtseinheit umfassen. Insbesondere kann hierbei die Positionierung und/oder Verschiebung des auf der Bildansichtseinheit dazustellenden Bildes in horizontaler Richtung unabhängig sein von einer Positionierung und/oder Verschiebung des auf der Bildansichtseinheit dazustellenden Bildes in vertikaler Richtung. Die Positionierung und/oder die Verschiebung des darzustellenden Bildes wird bevorzugt mittels der Recheneinheit gesteuert. Hierzu kann die Bilddarstellungseinheit auch eine Positioniereinheit, beispielsweise eine mechanische Positioniereinheit, umfassen. Zudem kann auch eine elektronische Anpassung auf einem Monitor und/oder einem Projektor mittels der Recheneinheit erfolgen. Derart kann besonders vorteilhaft die Bildbereitstellungseinheit auf unterschiedliche Bildansichtseinheiten und/oder auf unterschiedliche Einheiten, wie beispielsweise auf unterschiedlich große Kopf-Hochfrequenzantenneneinheiten, an denen die Bildansichtseinheit angeordnet ist, angepasst werden. Zudem kann hierdurch ein Aufwand zur Einstellung der Patientenunterhaltungseinheit für einen Benutzer vorteilhaft reduziert werden.

In einer vorteilhaften Weiterbildung des erfindungsgemäßen Verfahrens kann es vorgesehen sein, dass die Einstellung der Bildgröße des bereitgestellten Bildes der Bildbereitstellungseinheit eine Einstellung der Bildgröße in horizontaler Richtung unabhängig von einer Einstellung der Bildgröße in vertikaler Richtung umfasst. Die Einstellung der Bildgröße in horizontaler Richtung unabhängig von einer Einstellung der Bildgröße in vertikaler Richtung wird bevorzugt mittels der Recheneinheit gesteuert. Beispielsweise kann die Einstellung der Bildgröße in horizontaler Richtung unabhängig von einer Einstellung der Bildgröße in vertikaler Richtung mittels einer Zoomeinheit der Patientenunterhaltungseinheit, insbesondere der Bildbereitstellungseinheit, erfolgen. Derart kann besonders vorteilhaft die Bildbereitstellungseinheit auf unterschiedliche Bildansichtseinheiten und/oder auf unterschiedliche Einheiten, wie beispielsweise auf unterschiedlich große Kopf-Hochfrequenzantenneneinheiten, an denen die Bildansichtseinheit angeordnet ist, angepasst werden. Zudem kann hierdurch ein Aufwand zur Einstellung der Patientenunterhaltungseinheit für einen Benutzer vorteilhaft reduziert werden.

Des Weiteren geht die Erfindung aus von einem Computerprogrammprodukt, welches ein Programm umfasst und direkt in einem Speicher einer programmierbaren Recheneinheit ladbar ist, mit Programmmitteln, um ein Verfahren zu einer Steuerung einer Patientenunterhaltungseinheit einer Magnetresonanzvorrichtung auszuführen, wenn das Programm in der Recheneinheit ausgeführt wird. Dabei benötigt das Computerprogramm eventuell Programmmittel, z.B. Bibliotheken und Hilfsfunktionen, um die entsprechenden Ausführungsformen des Verfahrens zu realisieren. Das Computerprogramm kann dabei eine Software mit einen Quellcode, der noch kompiliert und gebunden oder der nur interpretiert werden muss, oder einen ausführbaren Softwarecode umfassen, der zur Ausführung nur noch in eine entsprechende Recheneinheit zu laden ist.

Das erfindungsgemäße Computerprogrammprodukt ist direkt in einen Speicher einer programmierbaren Recheneinheit ladbar und weist Programmcode-Mittel auf, um ein erfindungsgemäßes Verfahren zu einer Steuerung einer Patientenunterhaltungseinheit einer Magnetresonanzvorrichtung auszuführen, wenn das Computerprogrammprodukt in der Recheneinheit ausgeführt wird. Das Computerprogrammprodukt kann ein Computerprogramm sein oder ein Computerprogramm umfassen. Dadurch kann das erfindungsgemäße Verfahren schnell, identisch wiederholbar und robust ausgeführt werden. Das Computerprogrammprodukt ist derart konfiguriert, dass es mittels der Recheneinheit die erfindungsgemäßen Verfahrensschritte ausführen kann. Die Recheneinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte des erfindungsgemäßen Verfahrens zu einer Steuerung einer Patientenunterhaltungseinheit einer Magnetresonanzvorrichtung effizient ausgeführt werden können. Das Computerprogrammprodukt ist beispielsweise auf einem computerlesbaren Medium gespeichert oder auf einem Netzwerk oder Server hinterlegt, von wo es in den Prozessor einer lokalen Recheneinheit geladen werden kann, der mit der Magnetresonanzvorrichtung direkt verbunden oder als Teil ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Recheneinheit ein erfindungsgemäßes Verfahren zu einer Steuerung einer Patientenunterhaltungseinheit einer Magnetresonanzvorrichtung ausführen. So kann das Computerprogrammprodukt auch den elektronisch lesbaren Datenträger darstellen. Beispiele für elektronisch lesbare Datenträger sind eine DVD, ein Magnetband, eine Festplatte oder ein USB-Stick, auf welchem elektronisch lesbare Steuerinformationen, insbesondere Software (vgl. oben), gespeichert ist. Wenn diese Steuerinformationen (Software) von dem Datenträger gelesen und in eine Steuerung und/oder Recheneinheit gespeichert werden, können alle erfindungsgemäßen Ausführungsformen des vorab beschriebenen Verfahrens zu einer Steuerung einer Patientenunterhaltungseinheit einer Magnetresonanzvorrichtung durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus dem im Folgenden beschriebenen Ausführungsbeispiel sowie anhand der Zeichnungen.

Es zeigen:
- Fig. 1: eine erfindungsgemäße Magnetresonanzvorrichtung mit einem ersten Ausführungsbeispiel einer Patientenunterhaltungseinheit in einer schematischen Darstellung,
- Fig. 2: eine erfindungsgemäße Magnetresonanzvorrichtung mit einem zweiten Ausführungsbeispiel einer Patientenunterhaltungseinheit in einer schematischen Darstellung und
- Fig. 3: ein erfindungsgemäßes Verfahren zu einer Steuerung einer Patientenunterhaltungseinheit einer Magnetresonanzvorrichtung.

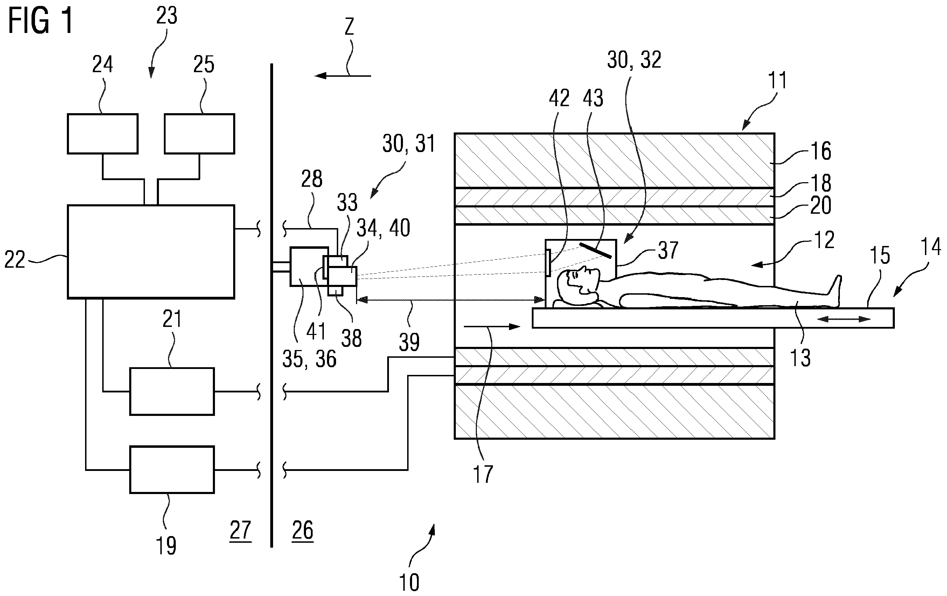

In der Fig. 1 ist eine Magnetresonanzvorrichtung 10 schematisch darstellt. Die Magnetresonanzvorrichtung 10 umfasst eine von einer Magneteinheit gebildeten Scannereinheit 11. Zudem weist die Magnetresonanzvorrichtung 10 einen Patientenaufnahmebereich 12 auf zu einer Aufnahme eines Patienten 13. Der Patientenaufnahmebereich 12 im vorliegenden Ausführungsbeispiel ist zylinderförmig ausgebildet und in einer Umfangsrichtung von der Scannereinheit 11, insbesondere von der Magneteinheit, zylinderförmig umgeben. Grundsätzlich ist jedoch eine davon abweichende Ausbildung des Patientenaufnahmebereichs 12 jederzeit denkbar. Der Patient 13 kann mittels einer Patientenlagerungsvorrichtung 14 der Magnetresonanzvorrichtung 10 in den Patientenaufnahmebereich 12 geschoben und/oder gefahren werden. Die Patientenlagerungsvorrichtung 14 weist hierzu einen innerhalb des Patientenaufnahmebereichs 12 bewegbar ausgestalteten Patiententisch 15 auf. Insbesondere ist hierbei der Patiententisch 15 in Richtung einer Längserstreckung des Patientenaufnahmebereichs 12 und/oder in z-Richtung der Magnetresonanzvorrichtung 10, insbesondere der Scannereinheit 11, bewegbar gelagert.

Die Scannereinheit 11, insbesondere die Magneteinheit, umfasst einen supraleitenden Grundmagneten 16 zu einem Erzeugen eines starken und insbesondere konstanten Grundmagnetfelds 17. Weiterhin weist die Scannereinheit 11, insbesondere die Magneteinheit, eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Scannereinheit 11, insbesondere die Magneteinheit, umfasst weiterhin eine Hochfrequenzantenneneinheit 20 zu einer Anregung einer Polarisation, die sich in dem von dem Grundmagneten 16 erzeugten Grundmagnetfeld 17 einstellt. Die Hochfrequenzantenneneinheit 20 wird von einer Hochfrequenzantennensteuereinheit 21 der Magnetresonanzvorrichtung 10 gesteuert und strahlt hochfrequente Magnetresonanzsequenzen in den Patientenaufnahmebereich 12 der Magnetresonanzvorrichtung 10 ein.

Zu einer Steuerung des Grundmagneten 16, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung, wie beispielsweise das Durchführen einer vorbestimmten bildgebenden Gradientenechosequenz. Zudem umfasst die Systemsteuereinheit 22 eine nicht näher dargestellte Auswerteeinheit zu einer Auswertung von medizinischen Bilddaten, die während der Magnetresonanzuntersuchung erfasst werden.

Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzbilder können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Die Scannereinheit 11 der Magnetresonanzvorrichtung 10 ist zusammen mit der Patientenlagerungsvorrichtung 14 innerhalb eines Untersuchungsraums 26 angeordnet. Die Systemsteuereinheit 22 dagegen ist zusammen mit der Benutzerschnittstelle 23 innerhalb eines Kontrollraums 27 angeordnet. Der Kontrollraum 27 ist getrennt von dem Untersuchungsraum 26 ausgebildet. Insbesondere ist der Untersuchungsraum 26 hinsichtlich einer Hochfrequenzstrahlung von dem Kontrollraum 27 abgeschirmt. Während einer Magnetresonanzuntersuchung befindet sich der Patient 13 innerhalb des Untersuchungsraums 26, dagegen befindet sich das medizinische Bedienpersonal innerhalb des Kontrollraums 27.

Des Weiteren umfasst die Magnetresonanzvorrichtung 10 für eine Unterhaltung und/oder einer Information des Patienten 13 eine Patientenunterhaltungseinheit 30 auf. Die Patientenunterhaltungseinheit 30 weist eine Bildbereitstellungseinheit 31 und eine Bildansichtseinheit 32 auf. Für eine Steuerung der Patientenunterhaltungseinheit 30, insbesondere der Bildbereitstellungseinheit 31, weist die Patientenunterhaltungseinheit 30 eine Recheneinheit 33 auf.

Die Recheneinheit 33 weist hierzu eine Software und/oder Computerprogramme, insbesondere eine Steuersoftware und/oder Steuerprogramme, zur Steuerung der Patientenunterhaltungseinheit 30, insbesondere der Bildbereitstellungseinheit 32, auf, die in einer nicht näher dargestellten Speichereinheit der Recheneinheit 33 gespeichert sind. Zudem kann die Speichereinheit zur Speicherung der Steuersoftware und/oder der Steuerprogramme auch außerhalb der Recheneinheit 33 angeordnet sein und dabei von der Magnetresonanzvorrichtung 10 umfasst sein. Des Weiteren kann die Speichereinheit auch eine zur Magnetresonanzvorrichtung 10 externe Speichereinheit umfassen, wie beispielsweise einen separaten Datenträger. Zur Steuerung der Patientenunterhaltungseinheit 30, insbesondere der Bildbereitstellungseinheit 32, wird die Software und/oder Computerprogramme von einem Prozessor der Recheneinheit 33 ausgeführt.

Die Recheneinheit 33 zur Steuerung der Patientenunterhaltungseinheit 30, insbesondere der Bildbereitstellungseinheit 32, ist im vorliegenden Ausführungsbeispiel separat zur Systemsteuereinheit 22 der Magnetresonanzvorrichtung 10 ausgebildet. Zudem kann die Recheneinheit 33 zur Steuerung der Patientenunterhaltungseinheit 30, insbesondere der Bildbereitstellungseinheit 32, auch innerhalb der Systemsteuereinheit 22 integriert sein. Ein Datenaustausch zwischen der Recheneinheit 33 und der Systemsteuerungseinheit 22 erfolgt über eine Datenübertragungseinheit 28 der Magnetresonanzvorrichtung 10. Die Datenübertragungseinheit 28 kann dabei zu einem kabelgebundenen Datenaustausch zwischen der Recheneinheit 33 und der Systemsteuereinheit 22 und/oder einer nicht näher dargestellten Speichereinheit der Magnetresonanzvorrichtung 10, insbesondre der Systemsteuereinheit 22, ausgelegt und/oder ausgebildet sein. Alternativ oder zusätzlich kann die Datenübertragungseinheit 28 auch zu einem kabellosen Datenaustausch zwischen der Recheneinheit 33 und der Systemsteuereinheit 22 und/oder einer nicht näher dargestellten Speichereinheit der Magnetresonanzvorrichtung 10, insbesondre der Systemsteuereinheit 22, ausgelegt und/oder ausgebildet sein.

Die Bildbereitstellungseinheit 31 ist außerhalb des Patientenaufnahmebereichs 12 innerhalb des Untersuchungsraums 26 angeordnet. Hierbei ist die Bildbereitstellungseinheit 31 derart an einer Wand des Untersuchungsraums 26 und/oder einem Halteelement, wie beispielsweise einem Stativ, angeordnet, dass die Bildbereitstellungseinheit 31, insbesondere eine Optikeinheit 34 der Bildbereitstellungseinheit 31, eine direkte Sicht in den Patientenaufnahmebereich 12 aufweist. Besonders vorteilhaft verläuft hierbei eine optische Achse der Bildbereitstellungseinheit 31, insbesondere der Optikeinheit 34 der Bildbereitstellungseinheit, durch den Patientenaufnahmebereich 12. Die optische Achse der Bildbereitstellungseinheit 31, insbesondere der Optikeinheit 34 der Bildbereitstellungseinheit, kann dabei im Wesentlichen parallel zu einer Längsrichtung des Patientenaufnahmebereichs 12 ausgerichtet und/oder ausgebildet sein. Die Bildbereitstellungseinheit 31 weist im vorliegenden Ausführungsbeispiel eine Projektionseinheit 35 mit einem Projektor 36 auf. Der Projektor 36 ist zu einer Bereitstellung, insbesondere einer Projektion, von Informationen und/oder Bildern auf die Bildansichtseinheit 32 ausgelegt und/oder ausgebildet.

Die Bildbereitstellungseinheit 31 umfasst zudem die Recheneinheit 33. Mittels der Recheneinheit 33 ist eine Bildgröße eines bereitgestellten Bildes der Bildbereitstellungseinheit 31 einstellbar. Hierbei ist von der Recheneinheit 33 die Bildgröße eines bereitgestellten Bildes des Bildbereitstellungseinheit 31 in Abhängigkeit von zumindest einen Untersuchungsparameter einstellbar. Der zumindest eine Untersuchungsparameter umfasst bevorzugt einen Positionsparameter und/oder einen Abstandsparameter. Der zumindest eine Untersuchungsparameter, insbesondere der Positionsparameter und/oder der Abstandsparameter, kann beispielsweise eine Position eines innerhalb des Patientenaufnahmebereichs 12 bewegbaren Patiententischs 15 sein, wobei an dem Patiententisch 15 die Bildansichtseinheit 32 der Patientenunterhaltungseinheit 30 angeordnet sein kann. Des Weiteren kann der zumindest eine Untersuchungsparameter, insbesondere der Positionsparameter und/oder der Abstandsparameter, eine Position des Patienten 13 innerhalb des Patientenaufnahmebereichs 12 während einer Magnetresonanzuntersuchung umfassen. Alternativ oder zusätzlich kann der zumindest eine Untersuchungsparameter, insbesondere der Positionsparameter und/oder der Abstandsparameter, auch eine Position einer Zubehöreinheit 37 innerhalb des Patientenaufnahmebereichs 12 umfassen, wie beispielsweise eine Kopf-Hochfrequenzantenneneinheit, an der die Bildansichtseinheit 33 der Patientenunterhaltungseinheit 30 angeordnet sein kann. Alternativ oder zusätzlich kann der zumindest eine Untersuchungsparameter, insbesondere der Positionsparameter und/oder der Abstandsparameter, auch einen Abstand 39 umfassen, wie beispielsweise einen Abstand 39 der Bildbereitstellungseinheit 31 zur Bildansichtseinheit 32.

Zu einer Bestimmung und/oder Erfassung des zumindest einen Untersuchungsparameters, insbesondere des Positionsparameters und/oder des Abstandsparameters, weist die Bildbereitstellungseinheit 31 eine Sensoreinheit 38 auf. Die Sensoreinheit 38 umfasst im vorliegenden Ausführungsbeispiel einen Abstandslaser. Die Sensoreinheit 38, insbesondere der Abstandslaser, ist an der Bildbereitstellungseinheit 31 angeordnet. Insbesondere ist hierbei die Sensoreinheit 38, insbesondere der Abstandslaser, an einer Optikeinheit 34 der Bildbereitstellungseinheit 31 angeordnet. Mittels der Sensoreinheit 38, insbesondere des Abstandslasers, kann ein Abstand 39 und/oder eine Entfernung von der Bildbereitstellungseinheit 31 zu der Bildansichtseinheit 32 und/oder zu einer Einheit, wie beispielsweise der Patiententisch 15 der Patientenlagerungsvorrichtung 14 und/oder der Zubehöreinheit 37, an der die Bildansichtseinheit 32 angeordnet ist, bestimmt und/oder erfasst werden. Zudem kann mittels der Sensoreinheit 38, insbesondere des Abstandslasers, ein Abstand 39 und/oder eine Entfernung von der Bildbereitstellungseinheit 31 und/oder zu dem Patienten, bestimmt und/oder erfasst werden.

Des Weiteren kann der Untersuchungsparameter, insbesondere der Positionsparameter und/oder der Abstandsparameter, auch mittels der Datenübertragungseinheit 28 von der Systemsteuereinheit 22 und/oder einer Speichereinheit der Magnetresonanzvorrichtung 10 auf die Recheneinheit 33 übertragen werden. Dies ist insbesondere dann der Fall, wenn für die anstehende Magnetresonanzuntersuchung eine genau und/oder exakt definierte Untersuchposition für den Patienten 13 und/oder die Zubehöreinheit 37 in der Systemsteuereinheit 22 und/oder der Speichereinheit der Magnetresonanzvorrichtung 10 hinterlegt und/oder gespeichert ist.

Die Bildbereitstellungseinheit 31 weist zur Einstellung der Bildgröße eines bereitgestellten Bildes eine Zoomeinheit 40 auf. Die Zoomeinheit 40 umfasst bevorzugt die Optikeinheit 34 der Bildbereitstellungseinheit 31, insbesondere des Projektors 36 der Projektionseinheit 35. Die Optikeinheit 34 umfasst im vorliegenden Ausführungsbeispiel eine einstellbare Optikeinheit 34, die bevorzugt eine optische Linseneinheit mit einzelnen optischen Linsenelementen umfasst. Die Zoomeinheit 40 umfasst bevorzugt eine motorgesteuerte Zoomeinheit 40 mit einen Einstellmotor, der von der Recheneinheit 33 gesteuert wird, wobei mittels des Einstellmotors ein Abstand zwischen einzelnen optischen Elementen, insbesondere zwischen einzelnen optischen Linsenelementen, der Optikeinheit 34 einstellbar ist. Durch die Einstellung des Abstands zwischen den einzelnen optischen Elementen, insbesondere zwischen den einzelnen optischen Linsenelementen, kann eine Bildgröße eines bereitgestellten Bildes der Bildbereitstellungseinheit 31 mittels der Recheneinheit 33 eingestellt werden. Die Zoomeinheit 40 ist hierbei an der Optikeinheit 34, insbesondere an der einstellbaren Optikeinheit 34, der Projektionseinheit 35, insbesondere des Projektors 36, angeordnet.

In einer alternativen Ausgestaltung der Erfindung, insbesondere einer alternativen Ausgestaltung der Bildbereitstellungseinheit 31, kann die Projektionseinheit 35 auch einen digitalen Projektor 36 umfassen. Hierbei würde auch die Zoomeinheit 40 eine digitale Zoomeinheit 40 umfassen, wobei mittels der digitalen Zoomeinheit 40, insbesondere der Recheneinheit 33, eine Einstellung einer Bildgröße und/oder eines Bildausschnitts vorgenommen werden kann. Die Recheneinheit 33 kann dabei zumindest teilweise einstückig mit der Zoomeinheit 40 ausgebildet sein und/oder die Zoomeinheit 40 von der Recheneinheit 33 umfasst sein.

Mittels der Projektionseinheit 36, insbesondere des Projektors 35, wird ein Bild bereitgestellt und auf die Bildansichtseinheit 32 projiziert. Das auf die Bildansichtseinheit 32 projizierte Bild soll dabei unabhängig von einem Abstand 39 des Patienten 13 und/oder der Bildansichtseinheit 32 zu der Bildbereitstellungseinheit 31 stets eine gleiche Größe auf der Bildansichtseinheit 32 umfassen. Die Bildgröße wird mithilfe der Recheneinheit 33 und der Zoomeinheit 40 an der Bildbereitstellungseinheit 31 eingestellt.

Des Weiteren weist die Bildbereitstellungseinheit 31 eine Positioniereinheit 41 auf, mittels der ein bereitgestelltes Bild in horizontaler Richtung und/oder in vertikaler Richtung positioniert werden kann. Die Positioniereinheit 41 umfasst in vorliegenden Ausführungsbeispiel eine mechanische Positioniereinheit 41 und wird von der Recheneinheit 33 gesteuert. Dabei ist die Positioniereinheit 41, insbesondere die mechanische Positioniereinheit 41, zusammen mit der Recheneinheit 33 derart ausgebildet, dass eine Positionierung und/oder Verschiebung des bereitgestellten Bildes und/oder eines auf die Bildansichtseinheit 32 projizierten Bildes in horizontaler Richtung unabhängig von einer Positionierung und/oder Verschiebung des bereitgestellten Bildes und/oder eines auf die Bildansichtseinheit 32 projizierten Bildes in vertikaler Richtung eingestellt werden kann. Mittels der Positioniereinheit 41 kann das bereitgestellte Bild und/oder das auf der Bildansichtseinheit 32 projizierte Bild auf eine Darstellungsfläche, insbesondere auf eine Projektionsleinwand 42, der Bildansichtseinheit 32 angepasst werden.

Die Bildansichtseinheit 32 ist während einer Magnetresonanzuntersuchung an einem Patienten 13 bevorzugt innerhalb des Patientenaufnahmebereichs 12 angeordnet. Im vorliegenden Ausführungsbeispiel ist die Bildbereitstellungseinheit 32 an einer Zubehöreinheit 37 der Magnetresonanzvorrichtung 10 angeordnet. Die Zubehöreinheit 37 umfasst im vorliegenden Ausführungsbeispiel eine lokale Hochfrequenzantenneneinheit, insbesondere eine lokale Kopf-Hochfrequenzantenneneinheit. An einer dem Gesicht des Patienten 13 zugewandten Seite der lokalen Kopf-Hochfrequenzantenneneinheit ist hierbei die Bildansichtseinheit 32 der Patientenunterhaltungseinheit 30 angeordnet. Zudem kann die Zubehöreinheit 37 weitere, dem Fachmann als sinnvoll erscheinenden Einheiten umfassen, an denen eine Anordnung der Bildansichtseinheit 32 der Patientenunterhaltungseinheit 30 sinnvoll ist.

In einer alternativen Ausgestaltung der Patientenunterhaltungseinheit 30 kann die Bildansichtseinheit 32 auch direkt an der Patientenlagerungsvorrichtung 14, insbesondere an dem bewegbaren Patiententisch 15 der Patientenlagerungsvorrichtung 14, angeordnet sein. Zudem kann in einer alternativen Ausgestaltung der Patientenunterhaltungseinheit 30 die Bildansichtseinheit 32 auch an einem den Patientenaufnahmebereich 12 umgebenden Gehäuse der Scannereinheit 11 angeordnet sein. Zudem ist auch eine separate, in den Patientenaufnahmebereich 12 einführbare, Halterung, wie beispielsweise ein Stativ zur Befestigung und/oder Anordnung der Bildansichtseinheit 32 innerhalb des Patientenaufnahmebereichs 12 während einer Magnetresonanzuntersuchung an dem Patienten 13 denkbar.

Die Bildansichtseinheit 32 weist im vorliegenden Ausführungsbeispiel einen Projektionsspiegel 43 und die Projektionsleinwand 42 auf. Das von der Bildbereitstellungseinheit 31, insbesondere dem Projektor 36, bereitgestellte Bild wird von dem Projektor 36 auf die Projektionsleinwand 42 der Bildansichtseinheit 32 projiziert. Die Projektionsleinwand 42 ist dabei im Wesentlichen senkrecht zu einer Projektionsrichtung und/oder eines Abstands 39 von der Bildbereitstellungseinheit 31 zur Bildansichtseinheit 32 angeordnet. Der Projektionsspiegel 43 der Bildansichtseinheit 32 ist dabei direkt in einem Sichtbereich und/oder einem Sichtfeld des Patienten 13 an der Zubehöreinheit 37, insbesondere der lokalen Kopf-Hochfrequenzantenneneinheit, angeordnet. Mittels des Projektionsspiegels 43 wird das auf die Projektionsleinwand 42 projizierte Bild für den Patienten 13 angezeigt.

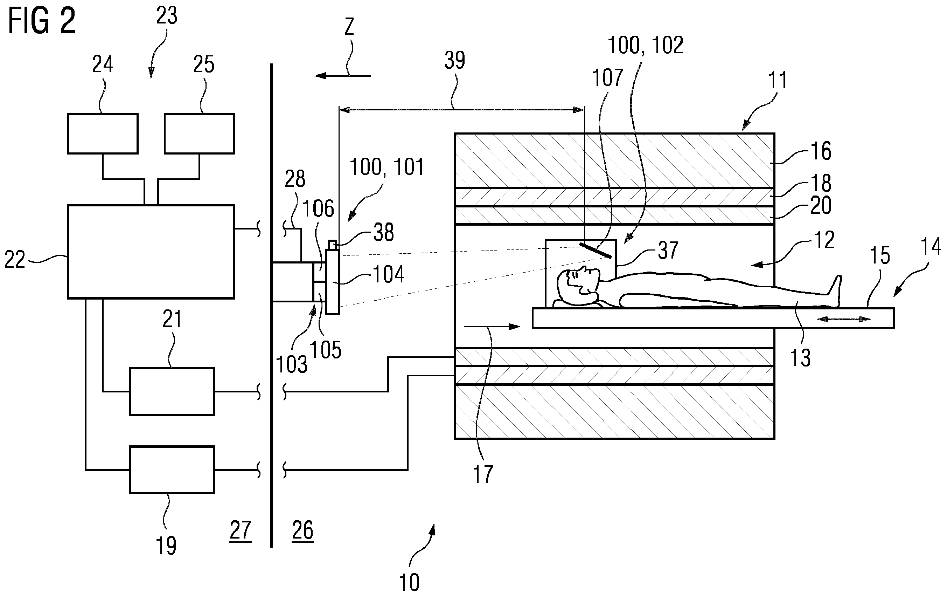

In Fig. 2 ist ein alternatives Ausführungsbeispiel einer Patientenunterhaltungseinheit 100 der Magnetresonanzvorrichtung 10 dargestellt. Im Wesentlichen gleichbleibende Bauteile, Merkmale und Funktionen sind grundsätzlich mit den gleichen Bezugszeichen beziffert. Die nachfolgende Beschreibung beschränkt sich im Wesentlichen auf die Unterschiede zu dem Ausführungsbeispiel in Fig. 1, wobei bezüglich gleichbleibender Bauteile, Merkmale und Funktionen auf die Beschreibung des Ausführungsbeispiels in Fig. 1 verwiesen wird.

Die Patientenunterhaltungseinheit 100 im vorliegenden Ausführungsbeispiel weist eine Bildbereitstellungseinheit 101 und eine Bildansichtseinheit 102 auf. Für eine Steuerung der Patientenunterhaltungseinheit 100, insbesondere der Bildbereitstellungseinheit 101, weist die Patientenunterhaltungseinheit 100 eine Recheneinheit 103 auf. Insbesondere kann mittels der Recheneinheit 103 eine Bildgröße eines bereitgestellten Bildes der Bildbereitstellungseinheit 101 eingestellt werden. Die Recheneinheit 103 im vorliegenden Ausführungsbeispiel ist gemäß der Ausführung zu Fig. 1 ausgebildet.

Die Bildbereitstellungseinheit 101 ist außerhalb des Patientenaufnahmebereichs 12 angeordnet. Hierbei ist die Bildbereitstellungseinheit 101 derart an einer Wand und/oder einem Halteelement, wie beispielsweise einem Stativ, angeordnet, dass die Bildbereitstellungseinheit 101 eine direkte Sicht in den Patientenaufnahmebereich 12 aufweist. Besonders vorteilhaft verläuft eine optische Achse der Bildbereitstellungseinheit 101 zumindest teilweise durch den Patientenaufnahmebereich 12. Die Bildbereitstellungseinheit 101 weist im vorliegenden Ausführungsbeispiel ein Display 104 und/oder einen Monitor auf.

Die Bildbereitstellungseinheit 101 weist zur Einstellung einer Bildgröße eines mittels der Bildbereitstellungseinheit 101 bereitgestellten Bildes eine Zoomeinheit 105 auf. Die Zoomeinheit 105 umfasst im vorliegenden Ausführungsbeispiel eine digitale Zoomeinheit 105. Die digitale Zoomeinheit 105 ist im vorliegenden Ausführungsbeispiel von der Recheneinheit 103 umfasst. Alternativ hierzu kann die digitale Zoomeinheit 105 auch separat zur Recheneinheit 103 ausgebildet sein.

Die Recheneinheit 103, insbesondere die digitale Zoomeinheit 105, stellt dabei die Bildgröße eines mittels der Bildbereitstellungseinheit 101 bereitgestellten Bildes in Abhängigkeit von zumindest einen Untersuchungsparameter, insbesondere einen Positionsparameter und/oder einen Abstandsparameter ein. Der zumindest eine Untersuchungsparameter kann dabei mittels einer Sensoreinheit 38 erfasst werden oder mittels einer Datenübertragungseinheit 28 an die Recheneinheit 103 übertragen werden. Je größer hierbei ein Abstand 39 zwischen der Bildbereitstellungseinheit 101, insbesondere zwischen dem Display 104 und/oder dem Monitor, und der Bildansichtseinheit 102 ist, desto größer wird eine Größe des bereitgestellten Bildes von der Zoomeinheit 105 zusammen mit der Recheneinheit 103 einstellt eingestellt. Zudem kann es auch sein, dass je größer ein Abstand 39 zwischen der Bildbereitstellungseinheit 101, insbesondere zwischen dem Display 104 und/oder dem Monitor, und der Bildansichtseinheit 102 ist, ein umso kleinerer Ausschnitt des vergrößert bereitgestellten Bildes von der Zoomeinheit 105 zusammen mit der Recheneinheit 103 einstellt wird. Bevorzugt weist hierbei die Bildbereitstellungseinheit 101, insbesondere das Display 104 und/oder der Monitor der Bildbereitstellungseinheit 101, eine hohe Auflösung auf, um eine hohe Bildschärfe der auf der Bildansichtseinheit 102 dargestellten Bilder und/oder Informationen zu erhalten.

Die Bildbereitstellungseinheit 101 umfasst des Weiteren eine Positioniereinheit 106 zur Positionierung des bereitgestellten Bildes und/oder eines anzuzeigenden Bildes in horizontaler Richtung und/oder in vertikaler Richtung. Die Positioniereinheit 106 kann dabei eine mechanische Positioniereinheit 106 umfassen, die von der Recheneinheit 103 gesteuert wird. Zudem kann die Positioniereinheit 106 auch eine digitale Positioniereinheit 106 umfassen, die bevorzugt von der Recheneinheit 103 umfasst ist. Zudem kann die Positioniereinheit 106, insbesondere die digitale Positioniereinheit 106, auch separat zur Recheneinheit 103 ausgebildet sein.

Die Bildansichtseinheit 102 weist im vorliegenden Ausführungsbeispiel einen Projektionsspiegel 107 auf, der das von dem Bildbereitstellungseinheit 101 bereitgestellte Bild, insbesondere das von dem Display 104 und/oder dem Monitor dargestellte Bild, für den Patienten 13 anzeigt. Insbesondere wird das von der Bildbereitstellungseinheit 101 bereitgestellte Bild, insbesondere das von dem Display 104 und/oder dem Monitor dargestellte Bild, direkt mittels des Projektionsspiegels 107 für den Patienten 13 angezeigt.

Die Bildansichtseinheit 102, insbesondere der Projektionsspiegel 107, ist auch im vorliegenden Ausführungsbeispiel an einer Zubehöreinheit 37 der Magnetresonanzvorrichtung 10 angeordnet. Die Zubehöreinheit 37 umfasst auch im vorliegenden Ausführungsbeispiel eine lokale Hochfrequenzantenneneinheit, insbesondere eine lokale Kopf-Hochfrequenzantenneneinheit. An einer dem Gesicht des Patienten 13 zugewandten Seite der lokalen Kopf-Hochfrequenzantenneneinheit ist hierbei die Bildansichtseinheit 102, insbesondere der Projektionsspiegel 107, der Patientenunterhaltungseinheit 100 angeordnet. Der Projektionsspiegel 107 ist dabei direkt in einem Sichtbereich und/oder einem Sichtfeld des Patienten 13 an der Zubehöreinheit 37, insbesondere der lokalen Kopf-Hochfrequenzantenneneinheit, angeordnet.

In einer alternativen Ausgestaltung der Patientenunterhaltungseinheit kann die Bildansichtseinheit 102 auch direkt an der Patientenlagerungsvorrichtung 14, insbesondere an dem bewegbaren Patiententisch 15 der Patientenlagerungsvorrichtung 14, angeordnet sein. Zudem kann in einer alternativen Ausgestaltung der Patientenunterhaltungseinheit 100 die Bildansichtseinheit 102 auch an einem den Patientenaufnahmebereich 12 umgebenden Gehäuse der Scannereinheit 11 angeordnet sein. Zudem ist auch eine separate, in den Patientenaufnahmebereich 12 einführbare, Halterung, wie beispielsweise ein Stativ zur Befestigung und/oder Anordnung der Bildansichtseinheit 102 innerhalb des Patientenaufnahmebereichs 12 während einer Magnetresonanzuntersuchung an dem Patienten 13 denkbar.

Die dargestellten Magnetresonanzvorrichtungen 10 können selbstverständlich weitere Komponenten umfassen, die Magnetresonanzvorrichtungen 10 gewöhnlich aufweisen. Eine allgemeine Funktionsweise einer Magnetresonanzvorrichtung 10 ist zudem dem Fachmann bekannt, so dass auf eine detaillierte Beschreibung der weiteren Komponenten verzichtet wird.

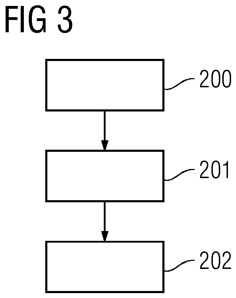

In Fig. 3 ist ein erfindungsgemäßes Verfahren zu einer Steuerung der Patientenunterhaltungseinheit 30, 100 der Magnetresonanzvorrichtung 10 dargestellt. Die Steuerung des erfindungsgemäßen Verfahrens zur Steuerung der Patientenunterhaltungseinheit 30, 100 erfolgt mittels der Recheneinheit 33, 103 der Patientenunterhaltungseinheit 30, 100.

In einem ersten Verfahrensschritt 200 erfolgt ein Bereitstellen zumindest eines Untersuchungsparameters der Magnetresonanzuntersuchung an dem Patienten 13. Der zumindest eine Untersuchungsparameter umfasst bevorzugt einen Positionsparameter und/oder Abstandsparameter. Das Bereitstellen des zumindest einen Untersuchungsparameters, insbesondere des Positionsparameters und/oder des Abstandsparameters, umfasst bevorzugt eine Erfassung des zumindest einen Untersuchungsparameters mittels der Sensoreinheit 38. Die Sensoreinheit 38 umfasst bevorzugt eine Kamera und/oder einen Abstandslaser und ist an der Bildbereitstellungseinheit 31, 101 angeordnet. Zudem kann das Bereitstellen des zumindest einen Untersuchungsparameters, insbesondere des Positionsparameters und/oder des Abstandsparameters, auch ein Übertragen des zumindest einen Untersuchungsparameters an die Recheneinheit 33, 103 umfassen. Der zumindest einen Untersuchungsparameters, insbesondere des Positionsparameters und/oder des Abstandsparameters, kann dabei in der Systemsteuereinheit 22 und/oder einer Speichereinheit hinterlegt und/oder gespeichert sein und mittels einer Datenübertragungseinheit 28 an die Recheneinheit 33, 103 übertragen werden.

In einem daran anschließenden zweiten Verfahrensschritt 201 wird von der Recheneinheit 33, 103 eine Bildgröße eines bereitgestellten Bildes der Bildbereitstellungseinheit 31, 101 der Patientenunterhaltungseinheit 30, 100 in Abhängigkeit von zumindest einen Untersuchungsparameter eingestellt. Zur Einstellung der Bildgröße eines bereitgestellten Bildes der Bildbereitstellungseinheit 31, 101 wird von der Recheneinheit 33, 103 die Zoomeinheit 40, 105 der Bildbereitstellungseinheit 31, 101 in Abhängigkeit von dem zumindest einen Untersuchungsparameter angesteuert.

Zudem kann neben der Einstellung der Bildgröße eines bereitgestellten Bildes der Bildbereitstellungseinheit 31, 101 in Abhängigkeit von zumindest einen Untersuchungsparameter in dem zweiten Verfahrensschritt 201 auch eine Positionierung des bereitgestellten Bildes erfolgen. Dabei kann eine Positionierung und/oder Einstellung in horizontaler Richtung unabhängig von einer Positionierung und/oder Einstellung in vertikaler Richtung sein. Die Positionierung erfolgt mittels einer Positioniereinheit 41, 106, die von der Recheneinheit 33, 103 in Abhängigkeit von dem zumindest einen Untersuchungsparameter gesteuert wird.

In einem dritten Verfahrensschritt 202 werden die in ihrer Größe eingestellten Informationen und/oder Bilder von der Bildbereitstellungseinheit 31, 101 an die Bildansichtseinheit 32, 102 übertragen und dort für einen Patienten 13 dargestellt und/oder angezeigt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Magnetresonanzvorrichtung mit einem Patientenaufnahmebereich und einer Patientenunterhaltungseinheit, wobei die Patientenunterhaltungseinheit eine außerhalb des Patientenaufnahmebereichs angeordnete Bildbereitstellungseinheit und eine Bildansichtseinheit aufweist,
**dadurch gekennzeichnet, dass** die Bildbereitstellungseinheit eine Recheneinheit umfasst, wobei mittels der Recheneinheit eine Bildgröße eines bereitgestellten Bildes der Bildbereitstellungseinheit einstellbar ist.

2. Magnetresonanzvorrichtung nach Anspruch 1,
**dadurch gekennzeichnet, dass** mittels der Recheneinheit die Bildgröße eines bereitgestellten Bildes der Bildbereitstellungseinheit in Abhängigkeit von zumindest einen Untersuchungsparameter einstellbar ist.

3. Magnetresonanzvorrichtung nach Anspruch 2,
**dadurch gekennzeichnet, dass** die Bildbereitstellungseinheit zumindest eine Sensoreinheit zu einer Bestimmung und/oder Erfassung des zumindest einen Untersuchungsparameters aufweist.

4. Magnetresonanzvorrichtung nach einem der Ansprüche 2 bis 3,
**gekennzeichnet durch** eine Datenübertragungseinheit, wobei mittels der Datenübertragungseinheit der zumindest eine Untersuchungsparameter an die Recheneinheit der Patientenunterhaltungseinheit übertragen wird.

5. Magnetresonanzvorrichtung nach einem der vorhergehenden Ansprüche,
**dadurch gekennzeichnet, dass** die Bildbereitstellungseinheit eine Zoomeinheit umfasst.

6. Magnetresonanzvorrichtung nach Anspruch 5,
**dadurch gekennzeichnet, dass** die Bildbereitstellungseinheit eine Projektionseinheit umfasst, an der die Zoomeinheit angeordnet ist.

7. Magnetresonanzvorrichtung nach einem der vorhergehenden Ansprüche,
**dadurch gekennzeichnet, dass** die Bildbereitstellungseinheit ein Display umfasst.

8. Magnetresonanzvorrichtung nach einem der vorhergehenden Ansprüche,
**dadurch gekennzeichnet, dass** die Bildbereitstellungseinheit eine Positioniereinheit zur Positionierung des bereitgestellten Bildes in horizontaler Richtung und/oder in vertikaler Richtung umfasst.

9. Magnetresonanzvorrichtung nach einem der vorhergehenden Ansprüche,
**dadurch gekennzeichnet, dass** die Bildansichtseinheit einen Projektionsspiegel und/oder eine Projektionsleinwand umfasst.

10. Magnetresonanzvorrichtung nach einem der vorhergehenden Ansprüche,
**dadurch gekennzeichnet, dass** die Bildansichtseinheit während einer Magnetresonanzuntersuchung an dem Patienten innerhalb des Patientenaufnahmebereichs angeordnet ist.

11. Magnetresonanzvorrichtung nach einem der vorhergehenden Ansprüche,
**gekennzeichnet durch** eine Zubehöreinheit, wobei die Bildansichtseinheit an der Zubehöreinheit angeordnet ist.

12. Verfahren zu einer Steuerung einer Patientenunterhaltungseinheit einer Magnetresonanzvorrichtung mittels einer Recheneinheit, wobei das Verfahren die folgenden Verfahrensschritte umfasst:
- Bereitstellen zumindest eines Untersuchungsparameters der Magnetresonanzuntersuchung und
- Einstellen einer Bildgröße eines bereitgestellten Bildes einer Bildbereitstellungseinheit der Patientenunterhaltungseinheit in Abhängigkeit von zumindest einen Untersuchungsparameter.

13. Verfahren nach Anspruch 12,
**dadurch gekennzeichnet, dass** das Bereitstellen des zumindest einen Untersuchungsparameter ein Erfassen des zumindest einen Untersuchungsparameters mittels zumindest einer Sensoreinheit erfasst umfasst.

14. Verfahren nach einem der Ansprüche 12 bis 13,
**dadurch gekennzeichnet, dass** das Bereitstellen des zumindest eine Untersuchungsparameter ein Übertragen des zumindest einen Untersuchungsparameters an die Recheneinheit umfasst.

15. Verfahren nach einem der Ansprüche 12 bis 14,
**dadurch gekennzeichnet, dass** die Einstellung der Bildgröße eine Positionierung des auf der Bildansichtseinheit darzustellenden Bildes umfasst.

16. Verfahren nach einem der Ansprüche 12 bis 15,
**dadurch gekennzeichnet, dass** die Einstellung der Bildgröße des darzustellenden Bildes der Bildbereitstellungseinheit eine Einstellung der Bildgröße in horizontaler Richtung unabhängig von einer Einstellung der Bildgröße in vertikaler Richtung umfasst.

17. Computerprogrammprodukt, welches ein Programm umfasst und direkt in einen Speicher einer programmierbaren Recheneinheit ladbar ist, mit Programmmitteln, um ein Verfahren zu einer Steuerung einer Patientenunterhaltungseinheit einer Magnetresonanzvorrichtung nach einem der Ansprüche 12 bis 16 auszuführen, wenn das Programm in der Recheneinheit ausgeführt wird.
